# EUROPÄISCHE PATENTSCHRIFT

(11) **EP 1 819 968 B1**
(45) Veröffentlichungstag und Bekanntmachung des Hinweises auf die Patenterteilung: **06.01.2010**
(21) Anmeldenummer: 05776466.4
(22) Anmeldetag: 29.08.2005
(51) Int. Cl.: F24J 2/10, F24J 2/04, F24J 2/05, H01L 31/058

(54) **KOLLEKTORMODUL FÜR THERMISCHE- UND ELEKTRISCHE ENERGIEGEWINNUNG**
COLLECTOR MODULE FOR GENERATING THERMAL AND ELECTRIC POWER
MODULE CAPTEUR POUR LA PRODUCTION D'ENERGIE THERMIQUE ET ELECTRIQUE

(30) Priorität: 31.08.2004 AT 14562004
(43) Veröffentlichungstag der Anmeldung: 22.08.2007
(73) Patentinhaber: Hadlauer, Martin, 8010 Graz (AT)
(72) Erfinder: Hadlauer, Martin, 8010 Graz (AT)
(74) Vertreter: Dilg, Haeusler, Schindelmann Patentanwaltsgesellschaft mbH
(86) Internationale Anmeldenummer: PCT/AT2005/000344
(87) Internationale Veröffentlichungsnummer: WO 2006/024060

(56) Entgegenhaltungen:
- WO-A-2005/003644
- DE-A1- 4 323 103
- DE-A1- 19 814 617
- US-A- 5 882 434

## Beschreibung

Die vorliegende Erfindung betrifft Sonnenkollektoren, gekoppelt an einen zweiachsigen Nachführmechanismus. Die Kollektoren bestehen jeweils aus den Grundeinheiten, Spiegel, Absorber und dem Traggestell mit Kollektorhaltevorrichtung.

Gattungsgemäße Kollektoren sind in der Patentanmeldung mit dem Aktenzeichen WO 2005/003644 A (SCRUBEI MARIO), ausführlich beschrieben. Je nach Kollektorausführung ist die Absorberfläche entweder mit einer thermisch selektiven Oberfläche beschichtet oder teils zusätzlich mit Solarzellen bestückt. Die Solarzellen werden über die Spiegel mit hoher Strahlungsintensität bestrahlt und über einen flüssigkeitsdurchströmten Wärmetauscher gekühlt.

Eine weitere mögliche Ausführung ist im Patent, US 5882434 A (HORNE ET AL), beschrieben. Hierbei wird die Strahlung über einen parabolähnlichen Spiegel auf einen ringförmig vorgelagerten Absorber mit Solarzellen geleitet. Der Absorber ist mit einem flüssigkeitsdurchströmten Kühlsystem mit der Funktion der Strahlungsfilterung und der zusätzlichen Strahlungsbündelung zu den Solarzellen versehen.

Eine weitere Ausführung ist in der Offenlegung, DE 19814617 A1 (UHRIG, WERNER), beschrieben. Hierbei stellt der Absorber ein luftgekühltes, an der Rückseite bestrahltes Solarzellenmodul dar, welches einem Spiegelsystem mit ein und zwei Umlenkungen vorgelagert ist.

Eine weitere Ausführung ist in der Offenlegung, DE 43 23 103 A1 (GEBHARDT KARIN), beschrieben. Hierbei werden in einer Kollektorvariante zwei Spiegel zur Bestrahlung eines plattenförmigen Absorbers, - ein vorgelagerter Spiegeltrichter für die Bestrahlung der sonnenzugewandten Seite und ein rückwärtig angeordneter parabolförmiger Spiegel zur Bestrahlung der Rückseite, vorgesehen.

Im Idealfall wird nicht nur die elektrische Energie sondern auch die anfallende Wärmeenergie genutzt. Naturgemäß wird an den Solarpaneelen in etwa 50 % der einfallenden Strahlung reflektiert. Um bei Kollektoren mit hohem Anteil an Solarzellen eine gute thermische Nutzung zu erreichen sollte daher die von den Solarzellen reflektierte Strahlung auf eine weitere Absorberfläche geleitet werden. Die Entscheidung ob schwerpunktrnäßig thermische Kollektoren mit hohen Temperaturen, oder Solarzellenkollektoren mit Hybridnutzung eingesetzt werden sollen ist oftmals sehr schwierig und hängt wesentlich von der zukünftigen Entwicklung im Solarzellensektor ab.

Die wesentliche Aufgabe der vorliegenden Erfindung ist es nun, Hybridkollektoren mit Nutzung der von den Solarzellen reflektierten Strahlung zur zusätzlichen Wärme- und Stromgewinnung vorzusehen. Zudem soll die Möglichkeit geboten werden, über eine modulare Bauweise thermische Kollektoren mit geringem Aufwand auf die betreffenden Hybridkollektoren umzurüsten zu können.

Dies wird erfindungsgemäß erreicht, indem die gespiegelte Strahlung auf einen Ringabsorber mit gekühlten Solarzellen geleitet wird, wobei sich der Strahlungskegel überkreuzt. Die an diesen Solarzellen reflektierte, nicht absorbierte Strahlung wird auf einen weiteren zentral gelegenen Absorber geleitet.

Eine modulare Bauweise wird erreicht indem der ringförmige Absorber (Ringabsorber), bestehend aus Solarzellen und Kühlkörper, und der zentral gelegene Absorber (Zentralabsorber) baulich getrennt sind.

Idealerweise sind Ringabsorber und Zentralabsorber hydraulisch in Serie verschaltet, wobei der kühle Rücklauf in den oberen Teil des Ringabsorbers eingeleitet wird. Um die Kühltemperatur zu den Solarzellen möglichst niedrig zu halten, ist der Ringabsorber thermisch vom wesentlich wärmeren Zentralabsorber getrennt. Dazu bietet sich an, einen Kunststoffring mit niedriger Wärmeleitfähigkeit dazwischenzugeben. Der Zentralabsorber ist idealerweise als Außenkalotte ausgeführt, wodurch ein hoher Anteil an Reflexionsstrahlung eingefangen werden kann. Aufgrund der speziellen Spiegelgeometrie mit dem erfindungsgemäß überkreuzenden Strahlungskegel ergibt sich kein Schattenwurf zu den Solar-paneelen. Ein zusätzlicher Vorteil ist, dass das Spiegelende bei gleicher Spiegelhöhe weiter nach außen rückt, wodurch der Spiegeltrichter etwas flacher wird, was wiederum bewirkt, dass mehr diffuse Einstrahlung zu den Absorbern gelangt. Um zusätzlich diffuse Strahlung einzufangen und Verluste durch Nachführfehler gering zu halten wird der Spiegelanfang weiter nach außen gerückt. Der freie Raum wird idealerweise mit Solarzellen ohne Kühlvorrichtung bestückt. Eine weitere Bestückung des Zentralabsorbers mit Solarzellen ist für den Fall, dass spezielle Solarzellen, welche das reflektierte Strahlungsspektrum aufnehmen können, eingesetzt werden, vorstellbar. Hierbei ist die elektrische Energiegewinnung im Vordergrund, thermische Energie wird eventuell nicht genutzt, sondern ist als reiner Kühlaufwand zu betrachten. Erfindungsgemäß kann bei Verwendung identer Bauteile allein durch Weglassen des Ringabsorbers ein vollkommen neuer Kollektortyp zur vorwiegend thermischen Nutzung gefertigt werden. Dabei rückt der Zentralabsorber nach oben und kommt direkt im Strahlungskegel des Spiegeltrichters zu liegen. Bei höheren Temperaturanforderungen bietet sich an, den Zentralabsorber mit einer Glaskuppel zu überdecken. Je nach Temperaturanforderung kann der Innenraum evakuiert werden oder mit Edelgas befüllt werden. Dies gilt sowohl für den thermischen Kollektor als auch für den Hybridkollektor.

Weitere Merkmale und Einzelheiten der vorliegenden Erfindung ergeben sich aus der nachfolgenden Figurenbeschreibung:

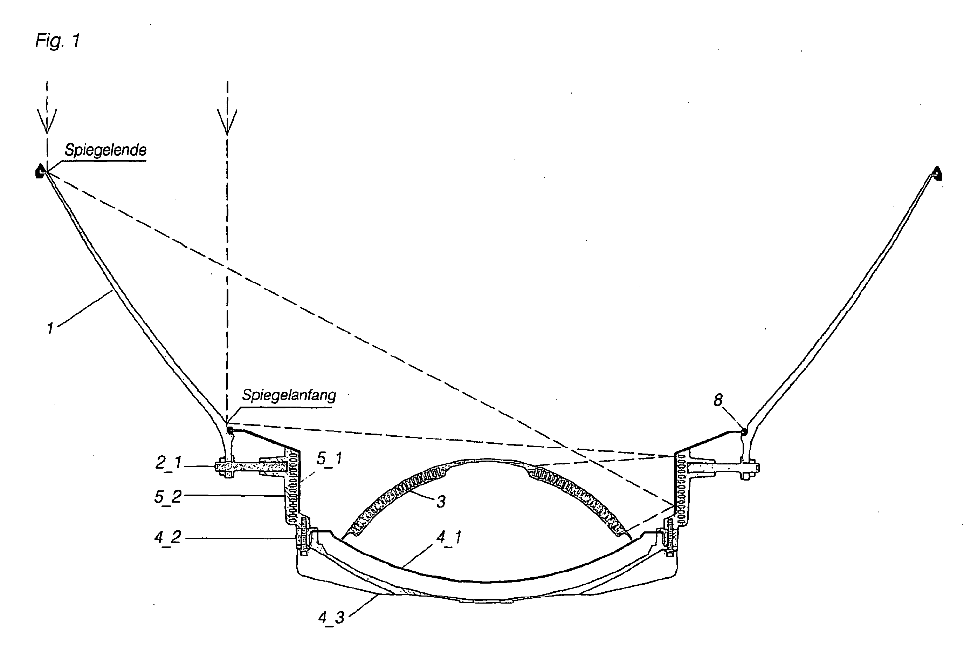

Fig.1 zeigt eine Darstellung eines Hybridkollektors im Schnitt. Der Ringabsorber 5, bestehend aus Kühlkörper 5_2 und Solarmodul 5_1 wird über einen Spiegeltrichter 1 bestrahlt. Ein Teil der Strahlung wird an dem ringabsorber mit gekühlten Solarzellen absorbiert, der restliche Anteil wird an den Zentralabsorber 3 weitergeleitet. Das Solarmodul ist über den Kühlkörper 5_2 hinweg nach außen gezogen und schließt am Ende an eine Gummidichtung 8 an. Der Spiegel 1 ist über drei oder mehrere Bolzen 2_1, welche am Ringabsorber 5 befestigt sind, beweglich gelagert. Dadurch unterliegt dieser keinen Spannungen aufgrund von Wärme-dehnungen. Sowohl Ringabsorber 5 als auch Zentralabsorber 3 sind auf einem Trägergestell 4 montiert. Das Trägergestell 4 hat die Aufgabe die Absorber 2, 3 thermisch zu trennen und die Anbindung zur Nachführvorrichtung zu gewährleisten. In dem hier gezeigten Fall ist das Trägergestell 4 in die Untereinheiten, Tragrahmen 4_3. Kunststoffring 4_2 und Innenkalotte 4_1 unterteilt. Denkbar ist, eine einzige Einheit 4 aus Kunststoff, zugleich mit Isolier- und Tragfunktion zu verwenden.

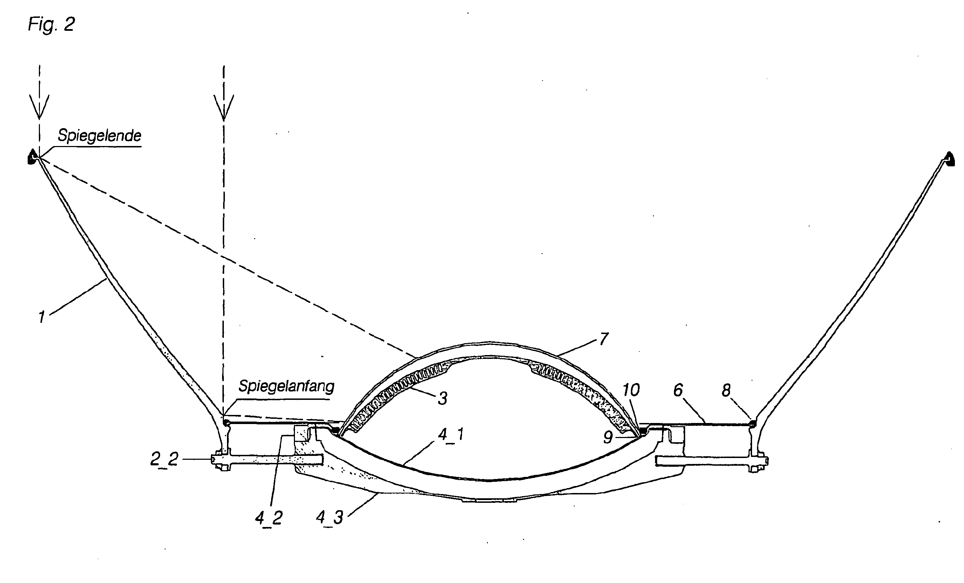

Fig. 2 zeigt eine Darstellung eines nicht beanspruchten thermischen Kollektors im Schnitt. Zwischen Spiegel und Absorber ist ein ebener Solarring 6 ohne Kühlvorrichtung vorgesehen. Der Spiegel 1 ist über drei oder mehrere Bolzen 2_2. welche am Traggestell 4 befestigt sind, beweglich gelagert. Der Absorber 3 ist von einer Glaskuppel 7 überdeckt. Bei hohen Prozesstemperaturen kann der Absorber durch Vakuum im inneren der Glaskuppel thermisch isoliert werden. Um das Vakuum über lange Zeit halten zu können, ist auf entsprechende Abdichtungen 9, 10 und ein diffusionsdichtes Trägergestell 4 zu achten.

Bei den in allen Figuren schematisch dargestellten Merkmalen wird darauf hingewiesen, dass die einzelnen Bauteile in allen verschiedenen Ausführungsvarianten und Materialien gefertigt sein können.

## Patentansprüche

1. Sonnenkollekormodul mit mindestens einem Ringabsorber (5,3) mit gekühlten Solarzellen einem Spiegel (1) und einem Trägergesteil (4), **dadurch gekennzeichnet, dass** der Spiegel (1) die Strahlen auf den Ringabsorber (5) mit gekühlten Solarzellen leitet, wobei sich der Strahlungskegel überkreuzt, von wo die nicht absorbierte Spiegelstrahlung auf einen Zentralabsorber (3) weitergeleitet wird.

2. Kollektormodul nach Anspruch 1, **dadurch gekennzeichnet, dass** der Ringabsorbe (5) mit gekühlten Solarzellen und der Zentralabsorber (3) baulich getrennt sind.

3. Kollektormodul nach einem der Ansprüche 1 bis 2, **dadurch gekennzeichnet, dass** der Zentralabsorber (3) als Außenkalotte ausgeführt ist.

4. Kollektormodul nach einem der Ansprüche 1 bis 3, **dadurch gekennzeichnet, dass** der Spiegel (1) aus einzelnen Segmenten zusammengesetzt ist.

5. Kottektormodul nach einem der Ansprüche 1 bis 4, **dadurch gekennzeichnet, dass** die Absorberfläche des Zentralabsorbers (3) teils thermisch selektiv beschichtet ist und teils mit Solarzellen-bestückt ist.

6. Kollektormodul nach einem der Ansprüche 1 bis 5, **dadurch gekennzeichnet, dass** der Ringabsorber (5) in die Untereinheiten, Solarmodul (5_1) und Kühlkörper (5_2) unterteilt ist, wobei das Solarmodul (5_1) über den Kühlkörper hinweg nach außen hin als flacher Trichter ausgeführt ist und Ober eine Dichtung (8) zum Spiegel (1) anschließt.

7. KoHektormodul nach einem der Ansprüche 1 bis 6, **dadurch gekennzeichnet, dass** der Spiegel (1) auf drei oder mehrere Bolzen, welche entweder auf dem Kühlkörper (5_2) oder auf dem Trägergestell (4) befestigt sind, gelagert ist.

8. Kollektormodul nach einem der Ansprüche 1 bis 7, **dadurch gekennzeichnet, dass** Ringabsorber (5) und Zentralabsorber (3) hydraulisch in Serie verschalten sind, wobei der kühle Rücklauf in den oberen Teil des Ringabsorbers (5) eingeleitet wird.

9. Kollektormodul nach einem der Ansprüche 1 bis 8, **dadurch gekennzeichnet, dass** der Zentralabsorber (3) von einer Glaskuppel (7) überdeckt wird, welche über eine Gummidichtung (10) niedergehalten und zugleich gegen Schmutz abgedichtet wird.

10. Kollektormodul nach Anspruch 9, **dadurch gekennzeichnet, dass** zusätzlich zur Gummidichtung (10) eine weitere Abdichtung (9) zur Verhinderung von Gasdiffusion vorgesehen ist.

11. Kollektormodul nach einem der Ansprüche 1 bis 10, wobei der Zentralabsorber (3) ein thermischer Absorber (3) ist.

12. Kollektormodul nach einem der Ansprüche 1 bis 10, wobei der Zentralabsorber (3) mit Solarzellen bestückt ist.

## Claims

1. Solar collector module having at least one annular absorber (5, 3) with cooled solar cells, a mirror (1), and a support frame (4), **characterized in that** the mirror (1) guides the radiation onto the annular absorber (5) with cooled solar cells, wherein the radiation cone intersects, from where the non-absorbed mirror radiation is relayed onto a central absorber (3).

2. Collector module according to claim 1, **characterized in that** the annular absorber (5) with cooled solar cells and the central absorber are structural separated from each other.

3. Collector module according to one of the claims 1 to 2, **characterized in that** the central absorber (3) is designed as an outer calotte.

4. Collector module according to one of the claims 1 to 3, **characterized in that** the mirror (1) is assembled by single segments.

5. Collector module according to one of the claims 1 to 4, **characterized in that** the absorber face of the central absorber (3) is partly thermally selective coated and partly equipped with solar cells.

6. Collector module according to one of the claims 1 to 5, **characterized in that** the annular absorber (5) is separated in the subunits solar module (5_1) and cooling element (5_2), wherein the solar module (5_1) is formed cross the cooling element outwards as a shallow funnel and attaches to the mirror (1) via a sealing (8).

7. Collector module according to one of the claims 1 to 6, **characterized in that** the mirror (1) is supported by three or multiple bolts, which are either fixed on the cooling element (5_2) or on the support frame (4).

8. Collector module according to one of the claims 1 to 7, **characterized in that** annular absorber (5) and central absorber (3) are hydraulically connected in series, wherein the cool reflux is introduced in the top part of the annular absorber (5).

9. Collector module according to one of the claims 1 to 8, **characterized in that** the central absorber (3) is covered by a glass dome (7), which is hold down and sealed against dirt by a rubber seal (10).

10. Collector module according to claim 9, **characterized in that** in addition to the rubber seal (10) a further sealing (9) is provided for avoiding gas diffusion.

11. Collector module according to any one of the claims 1 to 10, wherein the central absorber (3) is a thermal absorber (3).

12. Collector module according to any one of the claims 1 to 10, wherein the central absorber (3) is equipped with solar cells.

## Revendications

1. Module capteur solaire comportant au moins un absorbeur annulaire (5, 3) à cellules solaires refroidies, un miroir (1) et un bâti porteur (4), **caractérisé en ce que** le miroir (1) dirige les rayons sur l'absorbeur annulaire (5) à cellules solaires refroidies, le cône de rayonnement se croisant, d'où le rayonnement du miroir non absorbé est retransmis sur un absorbeur central (3).

2. Module capteur selon la revendication 1, **caractérisé en ce que** l'absorbeur annulaire (5) à cellules solaires refroidies et l'absorbeur central (3) sont séparés par construction.

3. Module capteur selon l'une des revendications 1 à 2, **caractérisé en ce que** l'absorbeur central (3) est réalisé sous la forme d'une calotte extérieure.

4. Module capteur selon l'une des revendications 1 à 3, **caractérisé en ce que** le miroir (1) est composé de segments individuels.

5. Module capteur selon l'une des revendications 1 à 4, **caractérisé en ce que** la surface absorbante de l'absorbeur central (3) est partiellement recouverte d'un revêtement thermique sélectif et partiellement équipée de cellules solaires.

6. Module capteur selon l'une des revendications 1 à 5, **caractérisé en ce que** l'absorbeur annulaire (5) est divisé en les deux sous-unités module solaire (5_1) et dissipateur thermique (5_2), le module solaire (5_1) étant réalisé par-dessus le dissipateur thermique vers l'extérieur sous la forme d'un entonnoir plat et se raccordant au miroir (1) par l'intermédiaire d'un joint (8).

7. Module capteur selon l'une des revendications 1 à 6, **caractérisé en ce que** le miroir (1) est monté sur trois ou plusieurs boulons qui sont fixés soit sur le dissipateur thermique (5_2), soit sur le bâti porteur (4).

8. Module capteur selon l'une des revendications 1 à 7, **caractérisé en ce que** l'absorbeur annulaire (5) et l'absorbeur central (3) sont branchés en série hydrauliquement, le retour froid étant introduit dans la partie supérieure de l'absorbeur annulaire (5).

9. Module capteur selon l'une des revendications 1 à 8, **caractérisé en ce que** l'absorbeur central (3) est recouvert par une coupole en verre (7) qui est maintenue par un joint en caoutchouc (10) et en même temps rendue étanche aux impuretés.

10. Module capteur selon la revendication 9, **caractérisé en ce qu'**un autre joint (9) destiné à empêcher la diffusion gazeuse est prévu en plus du joint principal (10).

11. Module capteur selon l'une des revendications 1 à 10, dans lequel l'absorbeur central (3) est un absorbeur thermique (3).

12. Module capteur selon l'une des revendications 1 à 10, dans lequel l'absorbeur central (3) est équipé de cellules solaires.
